Europäisches Patentamt

European Patent Office

Office européen des brevets

(11) Publication number: **0 046 012**
**B1**

## EUROPEAN PATENT SPECIFICATION

(45) Date of publication of patent specification: **19.04.89**

(51) Int. Cl.⁴: **G 11 C 19/08**

(21) Application number: **81303185.3**

(22) Date of filing: **13.07.81**

(54) **A bubble memory system and a numerical control apparatus comprising such system.**

(30) Priority: **15.07.80 JP 96387/80**

(43) Date of publication of application:
**17.02.82 Bulletin 82/07**

(45) Publication of the grant of the patent:
**19.04.89 Bulletin 89/16**

(84) Designated Contracting States:
**DE FR GB**

(56) References cited:
**EP-A-0 013 192**
**FR-A-2 172 675**
**FR-A-2 356 985**
**US-A-3 786 445**
**US-A-4 180 863**

**NTG-Fachberichte, 1977, pages 210-231**

(73) Proprietor: **FANUC LTD**
**3580, Shibokusa Aza-Komanba Oshino-mura**
**Minamitsuru-gun Yamanashi 401-05 (JP)**

(72) Inventor: **Ryoji, Imazeki**
**987-44, Naganuma-cho Hachioji-shi**
**Tokyo (JP)**
Inventor: **Hidetsugu, Komiya**
**1-17-20, Asahigaoka Hino-shi**
**Tokyo (JP)**
Inventor: **Michiya, Inoue**
**5-28-6, Nishihirayama Hino-shi**
**Tokyo (JP)**

(74) Representative: **Billington, Lawrence Emlyn**
**et al**
**HASELTINE LAKE & CO Hazlitt House 28**
**Southampton Buildings Chancery Lane**
**London WC2A 1AT (GB)**

## Description

This invention relates to a bubble memory system and a numerical control apparatus comprising such system.

Numerical control devices for controlling machine tools have recently been adapted to employ bubble memories rather thun paper tapes as the storage medium. These bubble memories are magnetically driven and therefore require a considerable amount of often expensive equipment to enable the bubble memory element to be used as the storage medium. Such equipment includes peripheral circuitry composed of a driver for driving a coil located within the bubble memory element and for driving a variety of gates, a sense amplifier for reading outputs, a function driver and a timing circuit, as well as a control circuit for controlling data read and write operations. The system that utilizes the bubble memory medium is therefore provided with (1) a bubble memory cassette which houses solely the bubble memory element, and (2) a cassette adapter which contains the peripheral circuitry and a holder for holding the inserted bubble cassette and for establishing electrical contact with the cassette, the cassette adapter responding to commands from the numerical control device to read information from the bubble memory cassette and to write information into memory. To reduce costs, it is so arranged that a single cassette adapter can be used in common by individual numerical control devices, the adapter being designed so that bubble memory cassettes storing different kinds of numerical control information can be exchanged merely by ejecting one cassette and replacing it by another. Such a system is disclosed in EP—A—0042749, published after the priority and application dates of the present European patent.

The conventional bubble memory cassette, however, accommodates only the bubble memory element. The sense amplifier that reads the data from the bubble memory element is provided within the cassette adapter. Consequently, signals travelling through the connector from the bubble memory element to the sense amplifier in the cassette adapter must traverse a considerable distance. This can lead to a problem in factories that employ machine tools, since sources of noise abound in such environments. If the numerical control device is installed in the vicinity of a noise source, the long wires passing through the connector between the bubble memory element and the sense ampifier will tend to intercept the noise, the latter entering the input side of the sense amplifer which operates at a low voltage level.

Another problem is encountered when it is desired to increase the storage capacity by installing a plurality of bubble memory element modules within the bubble memory cassette. Specifically, the greater number of modules increases the number of connecting wires between the bubble memory element and the sense amplifier, thereby necessitating a connector of a large size.

In FR—A—2 172 675 it is proposed to replace the then usual punched tape in NC systems by a semiconductor memory module (equivalent to a cassette) which can be introduced in a separate but non-portable controller which is permanently connected via a cable to the machine tool to be controlled. The controller has an adapter part which comprises the circuitry for cooperating with the module.

FR—A—2 356 985 discloses the use of a semiconductor memory module (cassette), which can be introduced into an adapter and controller unit fixedly attached to a machine tool. The read/write circuitry forms part of this unit.

In US—A—3 786 445 an integrated magnetic bubble and semiconductor device is disclosed. In order to avoid the need for an electrical interface to peripheral control and sensing circuitry the bubble device and the electronic circuitry (in particular the sensing and amplifying means) are mounted in close proximity on a common semiconducting substrate. This close proximity, it is stated, decreases noise picked up by the sense amplifier.

US—A—4 180 863 describes a device in which a number of modular magnetic domain devices are permanently mounted on a common substrate, which also carries a number of sense amplifiers and associated drive and other support circuitry. The modules are not individually selectable.

EP—A—13192 describes a credit card system in which the card is to be inserted in a fixed data processing station. The card bears a magnetic bubble memory in which an identification code is stored and which cooperates with the station. The possibility is mentioned to introduce several cards simultaneously. The signal read out from the memory under control by the station is inputted to a comparator circuit mounted on the card. If any amplification of the signal would be required, the amplifying means would have to be on the card also.

In NTG Fachberichte, 1977, pp 210—231, in particular p.217, penultimate paragraph, the possibility is considered of bubble memories in cassette form.

According to a first aspect of the present invention there is provided a bubble memory system for use in exchanging information with a host system, the bubble memory system being portable whereby it can be carried from, and connected to, one host system after another, thereby to permit the host systems sequentially to cooperate with the bubble memory system, the bubble memory system comprising a cassette adapter, and a bubble memory cassette which accommodates a storage medium comprising a plurality of bubble memory element modules, the cassette being capable of being inserted into and withdrawn from the cassette adapter which is interposed between the bubble memory element modules and a host system when the bubble memory system is in use, the cassette adapter including a control circuit for use in exchanging information between the bubble memory cassette and such host system, and the cassette having built-into it a sense amplifier for the bubble memory element modules, and a selector to enable information exchange to take place via the sense amplifier with a bubble memory element module which is selected by said selector. A further aspect of the invention is set out in independent claim 2.

An embodiment may be employed to shorten, to as great an extent as possible, the wiring distance between the bubble memory element and the sense amplifier in a portable bubble memory cassette apparatus, thereby to enhance the reliability of the apparatus in an electrically noisy environment.

The invention may provide a bubble memory cassette for use in a portable bubble memory cassette apparatus, in which there is no increase in the number of connecting wires between the bubble memory cassette and the cassette adapter even when the bubble memory cassette is provided with a plurality of bubble memory element modules.

The present invention may provide a bubble memory cassette for use in a portable bubble memory cassette apparatus, in which a plurality of bubble memory element modules provided within a bubble memory cassette can be employed selectively by switching among them through use of a changeover switch provided in the bubble memory cassette.

Other features and advantages of embodiments of the invention will be apparent from the following description taken in connection with the accompanying drawings, in which:

Fig. 1 is an illustrative view of a numerical control apparatus according to the invention, which is useful in describing a portable cassette memory system employing a bubble memory cassette in accordance with the present invention, and

Fig. 2 is a block diagram of a portable cassette adapter and a bubble cassette.

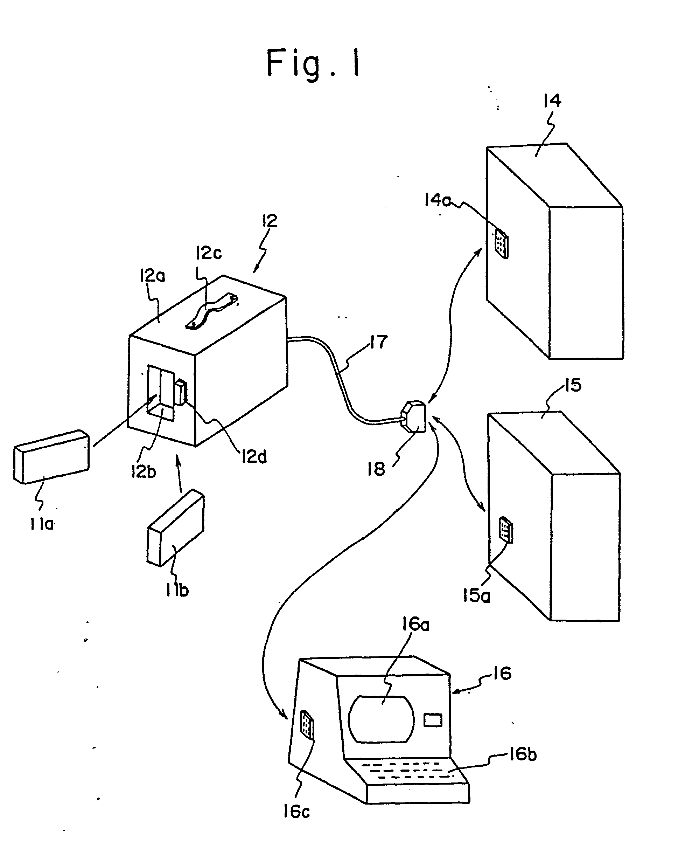

Referring first to Fig. 1, numerals 11a, 11b each denote a cassette-type storage medium (referred to as bubble memory cassette hereafter) having a bubble memory element. A portable cassette adapter 12 has a casing 12a which accommodates the abovementioned peripheral circuitry and control circuit, and which is formed to include a cassette holder 12b for retaining whichever of the bubble memory cassettes 11a, 11b has been inserted therein, and for providing electrical connection to the housed peripheral circuitry and control circuit. The casing 12a is small in size and is provided at its top with a handle 12c for easy carrying, so that the entire cassette adapter 12 is portable. Further, an eject lever 12d is provided on the side of the cassette holder, the lever being used to eject a bubble memory cassette which has been inserted into the holder 12b. Numerical control (NC) devices, serving as host systems, are indicated at numerals 14, 15. The NC devices include a built-in memory for storing a part program, as well as receptacles 14a, 15a, respectively, which are installed in the casing to make possible electrical connection between the NC device and the cassette adapter 12 via a cable and plug mentioned below. A programming apparatus 16, for the purpose of writing a part program into the bubble memory cassettes 11a, 11b, includes a display section 16a and a keyboard 16b, as well as a receptacle 16c which is installed in the casing to make possible electrical connection between the programming apparatus 16 and the cassette adapter 12 through the cable and plug. The cable, denoted by numeral 17, has one end thereof connected directly to the circuitry housed within the cassette adapter, and has the other end thereof connected to a connector 18 which is adapted to be plugged into any of the receptacles 14a, 15a, 16c. Thus, the cable 17 and connector 18 enable an exchange of signals and information between the cassette adapter 12, specifically the peripheral circuitry and control circuit housed within the cassette adapter 12, and either of the NC devices 14, 15 or programming apparatus 16, and permit a part program to be read from or written into either of the bubble cassettes 11a, 11b.

In operation, assume that the NC device 14 is to execute numerically controlled machining using a part program which has been stored in the bubble memory cassette 11a. In this case the bubble memory cassette 11a is inserted into the cassette holder 12b of the cassette adapter 12, and the connector 18 is plugged into the receptable 14a of the NC device 14. This establishes the electrical connection between the bubble memory cassette 11a and the portable cassette adapter 12, and between the portable cassette adapter 12 and the NC device 14. Once these connections have been made the part program stored in the bubble cassette 11a is transferred to and stored in the memory that is built in the NC device 14. The NC device 14 then executes a numerical control operamion on the basis of the part program. Similarly, if the NC device 15 is to execute numerically controlled machining using the part program stored in the bubble memory cassette 11a, the connector 18 is plugged into the receptacle 15a to transfer and store the program in the NC device 15 as described above. Further, a numerically controlled machining operation on the basis of a part program stored in the bubble memory cassette 11b can be carried out merely by inerting the bubble memory cassette 11b into the cassette holder 12a. To exchange cassettes, the eject lever 12d is depressed to eject the bubble memory cassette, accommodated within the cassette holder 12b, to a position where it can removed by hand. The operator then withdraws the ejected cassette from the cassette holder 12a and forcibly inserts a new bubble memory cassette into the cassette holder until the cassette is received at the operating position.

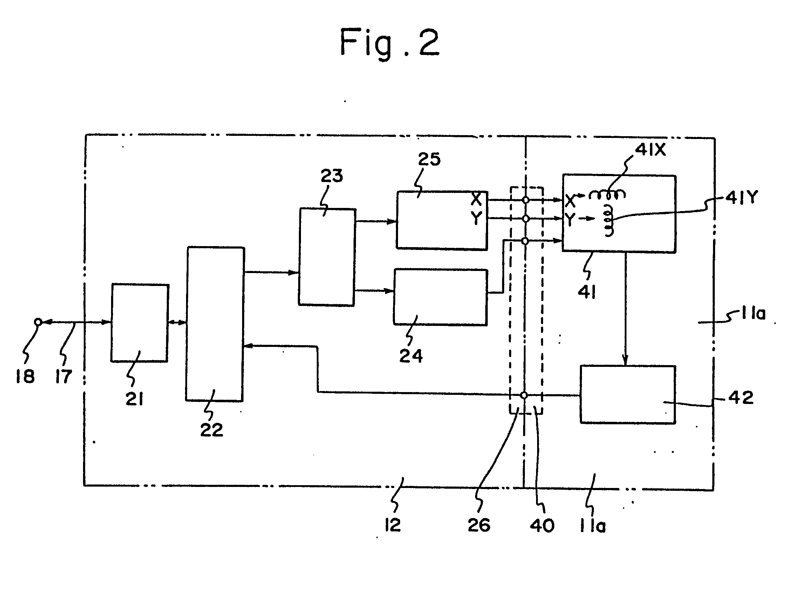

Fig. 2 is a block diagram showing the principal components constituting the portable cassette adapter 12 and a bubble memory cassette, such as the bubble memory cassette 11a. Specifically, the portable cassette adapter 12 includes an interface circuit 21 for the connection to the host system, a control circuit 22 for generating a variety of necessary signals and for controlling write signal inputs and the delivery of read signals and the like, a timing circuit 23, a function driver 24, timed by the timing circuit 23, for producing signals that enable signal read and write operations, and a coil driver 25, timed by the timing circuit 23, for generating two sinusoidal signals each having a frequency of 100kHz, the signals differing in phase by 90°. A receptacle 26 is provided in the cassette holder 12b of the portable cassette adapter 12. The bubble memory cassette 11a is provided with a connector 40 which is brought into electrical connection with the receptacle 26 when the bubble memory cassette 11a is inserted into the cassette holder 12b of the portable cassette adapter 12. The bubble memory cassette further includes a bubble memory module 41, and a sense amplifier 42 for reading out the data stored in the bubble memory module 41. The bubble memory module 41 has drive coils 41X, 41Y for converting, into a revolving magnetic field, the two sinusoidal currents, having the phase difference of 90°, obtained from the coil driver 25.

In reading data from the bubble memory module 41 in response to a signal from the function driver 24, the data signal immediately enters the sense amplifier 42 disposed in close proximity to the bubble memory module 41 within the cassette casing which it shares with the module. The sense amplifier 42 delivers the data signal to the portable cassette adapter 12 following amplification of the signal.

In a case where a plurality of bubble memory modules are installed within the bubble memory cassette 11a, a selector is provided within the sense amplifier 42, the arrangement being such that switching the selector supplies the sense amplifier with a data signal obtained from the desired bubble memory module designated by the selector. With such an arrangement, and with the addition of only a small quantity of wiring for driving the selector, the number of output lines from the sense amplifier is the same as when only a single bubble memory module is provided.

The sense amplifier is provided within the bubble memory cassette, so that the distance between the sense amplifier and the bubble memory module is much shorter than in a prior-art arrangement. As a result, externally generated noise is less likely to enter the sense amplifier input side; hence, data read-out proceeds with a higher degree of reliability. In addition, by providing a simple selector, a single sense amplifier suffices even when the bubble memory cassette is provided with a plurality of bubble memory modules. Thus there is no increase in the number of sense amplifier output lines despite the greater number of bubble memory modules.

As many apparently widely different embodiments of this invention may be made without departing from the spirit and scope thereof, it is to be understood that the invention is not limited to the specific embodiments thereof except as defined in the appended claims.

## Claims

1. A bubble memory system for use in exchanging information with a host system, the bubble memory system being portable whereby it can be carried from, and connected to, one host system after another, thereby to permit the host systems sequentially to cooperate with the bubble memory system, the bubble memory system comprising a cassette adapter and a bubble memory cassette which accommodates a storage medium comprising a plurality of bubble memory element modules, the cassette being capable of being inserted into and withdrawn from the cassette adapter which is interposed between the bubble memory element modules and a host system when the bubble memory system is in use, the cassette adapter including a control circuit for use in exchanging information between the bubble memory cassette and such host system, and the cassette having built-into it a sense amplifier for the bubble memory element modules, and a selector to enable information exchange to take place via the sense amplifier with a bubble memory element modules which is selected by said selector.

2. Numerical control apparatus comprising a plurality of numerical control devices each of which includes a built-in memory for storing a part program, a programming apparatus for writing a part program for the numerical control devices, and a bubble memory system for use in exchanging information with any one of the numerical control devices and the programming apparatus as a host system, the bubble memory system being portable whereby it can be carried and connected to the programming apparatus for writing a part program into the bubble memory system, and then carried and connected to the numerical control devices in turn so that the part program written-into the bubble memory system can be written-into the built-in memories of the numerical control devices, the bubble memory system comprising a cassette adapter and a bubble memory cassette which accommodates a storage medium comprising a plurality of bubble memory element modules, the cassette being capable of being inserted into and withdrawn from the cassette adapter which is interposed between the bubble memory element modules and a host system when the bubble memory system is in use, the cassette adapter including a control circuit for use in exchanging information between the bubble memory cassette and such host system, and the cassette having built-into it a sense amplifier for the bubble memory element modules, and a selector to enable information exchange to take place via the sense amplifier with a bubble memory element module which is selected by said selector.

**Patentansprüche**

1. Blasenspeichersystem zur Benutzung beim Austauschen von Information mit einem Hilfssystem, wobei das Blasenspeichersystem tragbar ist, wodurch es zu mehreren Hilfssystemen-eines nach dem anderen-getragen und mit dem jeweiligen Hilfssystem verbunden werden kann, um dadurch den Hilfssystemen zu erlauben, aufeinanderfolgend mit dem Blasenspeichersystem zusammenzuarbeiten, welches Blasenspeichersystem einen Kassettenadapter und eine Blasenspeicherkassette umfaßt, die ein Speichermedium aufnimmt, das eine Vielzahl von Blasenspeicherelement-Moduln enthält, wobei die Kassette in den Kassettenadapter, der zwischen die Blasenspeicherelement-Moduln und ein Hilfssystem geschaltet ist, wenn das Blasenspeichersystem in Betrieb ist, einsetzbar und aus diesem entfernbar ist, wobei der Kassettenadapter eine Steuerschaltung zur Benutzung beim Austauschen von Information zwischen der Blasenspeicherkassette und einem derartigen Hilfssystem enthält und wobei die Kassette in sich eingebaut einen Abfrageverstärker für die Blasenspeicherelement-Moduln und eine Wähleitrichtung aufweist, die erlaubt, daß ein Informationsaustausch über den Abfrageverstärker mit einem Blasenspeicherelement-Modul, der durch die Wähleinrichtung ausgewählt ist, stattfindet.

2. Vorrichtung zur numerischen Steuerung, mit einer Vielzahl von Einrichtungen zur numerischen Steuerung, wovon jede einen eingebauten Speicher zum Speichern eines Teilprogramms, eine Programmiervorrichtung zum Schreiben eines Teilprogramms für die Einrichtungen zur numerischen Steuerung und ein Blasenspeichersystem zur Benutzung beim Austauschen von Information mit irgendeiner der Einrichtungen zur numerischen Steuerung und der Programmiervorrichtung als ein Hilfssystem enthält, wobei das Blasenspeichersystem tragbar ist, wodurch es zum Einschreiben eines Teilprogramms in das Blasenspeichersystem zu der Programmiervorrichtung getragen und mit dieser verbunden werden kann und dann der Reihe nach zu den Einrichtungen zur numerischen Steuerung getragen und mit diesen verbunden werden kann, so daß das Teilprogramm, das in das Blasenspeichersystem eingeschrieben ist, in die eingebauten Speicher der Einrichtungen zur numerischen Steuerung eingeschrieben werden kann, welches Blasenspeichersystem einen Kassettenadapter und eine Blasenspeicherkassette umfaßt, die ein Speichermedium aufnimmt, das eine Vielzahl von Blasenspeicherelement-Moduln enthält, wobei die Kassette in den Kassettenadapter, der zwischen die Blasenspeicherelement-Moduln und ein Hilfssystem geschaltet ist, wenn das Blasenspeichersystem in Betrieb ist, einsetzbar und aus diesem entfernbar ist, wobei der Kassettenadapter eine Steuerschaltung zur Benutzung beim Austauschen von Information zwischen der Blasenspeicherkassette und einem derartigen Hilfssystem enthält und wobei die Kassette in sich eingebaut einen Abfrageverstärker für die Blasenspeicherelement-Moduln und eine Wähleinrichtung aufweist, die erlaubt, daß ein Informationsaustausch über den Abfrageverstärker mit einem Blasenspeicherelement-Modul, der durch die Wähleinrichtung ausgewählt ist, stattfindet.

**Revendications**

1. Un système pour mémoires à bulles destiné à être utilisé dans un échange d'informations avec un système hôte, le système pour mémoire à bulles étant portatif de sorte qu'il peut être transporté d'un système hôte à un autre, et connecté à ceux-ci, afin de permettre, de ce fait, que les systèmes hôtes coopèrent de manière séquentielle avec le système pour mémoire à bulles, le système pour mémoire à bulles comprenant un adaptateur de cassettes et une cassette à mémoire à bulles qui reçoit un support de stockage comprenant un ensemble de modules d'éléments de mémoire à bulles, la cassette étant susceptible d'être insérée dans l'adaptateur de cassettes, et d'en être retirée, ce dernier étant interposé entre les modules d'éléments pour mémoire à bulles et un système hôte lorsque le système pour mémoire à bulles est en fonctionnement, l'adaptateur de cassettes comprenant un circuit de commande destiné à être utilisé pour un échange d'informations entre la cassette à mémoire à bulles et un tel système hôte, et la cassette comportant intégré à celle-ci un amplificateur de détermination pour les modules d'éléments de mémoire à bulles, et un sélecteur destiné à permettre un échange d'informations de se produire via l'amplificateur de détermination avec un module d'éleents de mémoire à bulles qui est sélectionné par ledit sélecteur.

2. Appareil de commande numérique comprenant un ensemble de dispositifs de commande numérique, chacun desquels incluant une mémoire intégrée pour la mémorisation d'un programme de pièce, un appareil de programmation pour l'écriture d'un programme de pièce destiné au dispositif de commande numérique, et un système pour mémoire à bulles destiné à être utilisé pour un échange d'informations avec l'un quelconque des dispositifs de commande numérieque et l'appareil de programmation en tant que système hôte, le système pour mémoire à bulles étant portatif de sorte qu'il peut être transporté et connecté à l'appareil de programmation pour l'écriture d'un programme de pièce dans le système pour mémoire à bulles, et ensuite transporté et connecté aux dispositifs de commande numérique tout à tour, de telle façon que les programme de pièce écrit dans le système pour mémoire à bulles peut être écrit dans les mémoires intégrées des dispositifs de commande numérique, le système pour mémoire à bulles comprenant un adaptateur de cassettes et une cassette à mémoire à bulles qui reçoit un support de stockage comprenant un ensemble de modules d'éléments de mémoires à bulles, la cassette étant susceptible d'être inséreée dans l'adaptateur de cassettes, et d'en être retirée, ce dernier étant interposé entre les modules d'éléments pour mémoire à bulles et un système hôte lorsque le système pour mémoires à bulles est en fonctionnement, l'adaptateur de cassettes comprenant un circuit de commande destiné à être utilisé pour un échange d'informations entre la cassette à mémoire à bulles et un tel système hôte, et la cassette comprenant, intégré à celle-ci, un amplificateur de détermination pour les modules d'éléments de mémoire à bulles, et un sélecteur destiné à permettre un échange d'informations de se produire via l'amplificateur de détermination avec un module d'éléments de mémoire à bulles qui est sélectionné par ledit sélecteur.

# Fig. 1

Fig. 2